# EUROPEAN PATENT SPECIFICATION

(11) **EP 0 541 273 B1**
(45) Date of publication and mention of the grant of the patent: **02.04.1997**
(21) Application number: 92309676.2
(22) Date of filing: 22.10.1992
(51) Int. Cl.: B32B 27/32, B32B 15/08

(54) **Metallized film structure and method**
Metallisierte Filmstruktur und Verfahren
Structure feuilletée métallisée et procédé

(30) Priority: 05.11.1991 US 788058; 08.11.1991 US 789560; 08.11.1991 US 789561
(43) Date of publication of application: 12.05.1993
(73) Proprietor: MOBIL OIL CORPORATION, Fairfax, Virginia 22037-0001 (US)
(72) Inventor: Migliorini, Robert Andrew, Hamden, Connecticut 06517 (US); Chu, Shaw-Chang, Princeton Junction, New Jersey 08550 (US); Johnson, James Arthur, Farmington, New York 14425 (US)
(74) Representative: Colmer, Stephen Gary

(56) References cited:
- EP-A- 325 952
- EP-A- 0 317 237
- EP-A- 0 340 037
- EP-A- 0 372 886
- DE-A- 3 300 411
- DE-U- 8 703 556
- DE-U- 8 808 158

## Description

The invention relates to a multi-layer film structure having a metallized surface.

Oriented plastic film, particularly biaxially oriented polypropylene films, are used widely as packaging materials for a variety of products including many popular snack foods such as crackers, nuts, potato chips, etc. Certain films are not generally suitable for use as containers for foods or as a wrapper for foods, medical compounds, beauty preparations and the like, unless the same is modified for the exclusion of gases.

The bonding of metals, such as, aluminum, silver, chromium, etc., to plastic films has allowed such films to replace metallic foils in many instances. The flexibility of the films necessitates the formation of a strong metal-plastic bond, and a number of approaches have been developed for providing such bonding.

In US-A-4345005 a homopolymer polypropylene core layer is coextruded with an ethylene propylene copolymer. The film is biaxially oriented and the copolymer layer is corona discharge treated. Thereafter, a metal coating is deposited onto the corona discharge treated layer by any suitable process such as, vacuum deposition. In order to enhance adhesion between the metal and plastic film, neither the core layer or outer layer(s) contain a slip agent in an amount which would deleteriously affect the metal/polymer bond. The resulting product has utility in flexible packaging. Polypropylene film employed for packaging purposes inherently permits the transmission of oxygen and water vapor from the outside of the film to the inside of package made up of the film. Oxygen and water vapor promote rapid deterioration of foods packaged in such a container, therefore, its exclusion or control is desired.

Documents DE-U-8703556, DE-A-3300411 and DE-U-8808158 describe packaging films with good barrier properties comprising a polymer substrate layer and a vinyl alcohol polymer or copolymer layer having deposited on a surface thereof a metallic layer.

It is an object of the present invention to present a metallized film and a method of forming the same which has a decreased oxygen transmission and water vapor transmission rate.

It is a further object of the present invention to provide an improved film structure which has low permeability to gas and moisture, particularly a film structure which has decreased oxygen and water vapor transmission rates.

It is another object of this invention to provide a metallized multi-layer film structure wherein the layers are bonded together with an exceptionally strong bonding force.

According to one aspect of the present invention there is provided a metallized film structure according to claim 1.

The embodiment in which said skin layer is either a blend of (a) a vinyl alcohol homo or copolymer and (b) an ethylene-acrylic acid copolymer will hereinafter be referred to as the first embodiment.

The embodiment in which said skin layer is either a blend of (a) a vinyl alcohol homopolymer or copolymer and (b) an ionic copolymer of ethylene and an ethylenically unsaturated monocarboxylic acid wherein at least 10% of the carboxylic acid groups are neutralized with an alkali metal ion will hereinafter be referred to as the second embodiment.

In the first and second embodiments the polymer substrate is preferably oriented and is desirably polypropylene or a copolymer thereof.

In the first and second embodiments the ratio of (a) to (b) is preferably from 10:90 to 90:10.

In the first embodiment the blend may be a blend of (a) a member selected from the group consisting of polyvinyl alcohol and ethylene-vinyl alcohol copolymer and (b).

In the second embodiment said blend may be a blend of (a) a member selected from the group consisting of polyvinyl alcohol and ethylene-vinyl alcohol copolymer and (b) an alkali metal salt of ethylene acrylic acid coplymer or ethylene methacrylic acid coplymer.

In the first and second embodiments the blend may be of (a) polyvinyl alcohol and (b) an ethylene-acrylic acid copolymer.

In the second embodiment the blend may comprise (a) polyvinyl alcohol and (b) an alkali metal salt of ethylene acrylic acid copolymer.

In the second embodiment the blend may comprise (a) polyvinyl alcohol and (b) an alkali metal salt of ethylene-methacrylic acid copolymer.

In both the first and second embodiments one side of said polypropylene substrate preferably carries a heat-seal skin layer, which is desirably a copolymer of ethylene and propylene or a terpolymer of ethylene, propylene and butene-1. The other side of said polypropylene substrate is preferably modified by a maleic anhydride grafted polypropylene homopolymer or copolymer.

It has been determined that the use of a maleic anhydride modified polypropylene homopolymer or copolymer becomes a part of the substrate surface either by being interblended therewith or by being coextruded thereon as a surface skin layer. This modified surface layer or skin layer itself cannot be separated from the substrate layer. In addition, it has been determined that with such a surface, a poly(vinyl alcohol) coating thereon adheres tenaciously to this material.

By a "maleic anhydride modified polypropylene homopolymer or copolymer" is meant the product resulting from the reaction between maleic anhydride and the thermal degradation product of polypropylene or polypropylene copolymer. Examples of this material can be found disclosed in US-A-3480580: particular attention is directed to Examples 3, 4 and 6 of this patent.

The maleic anhydride modified polypropylene or a copolymer thereof can be prepared by a fairly simple process. For example, about 125 grams of low viscosity polypropylene of 3,300 centipoise at 190°C. and 7.5 grams of maleic anhydride are placed in a 500 ml. glass, round-bottom flask. This flask has 3 necks and is fitted with a metal sweep stirrer, a dropping funnel, and a steam-jacketed condenser to return maleic anhydride which boils out of the reaction mixture. The flask is lowered into a Wood's metal bath at a temperature of about 200°C. After about 1 hour the product is poured from the flask onto a metal tray. The waxy product will have a melt viscosity of 3,600 centipoise at 190°C and a saponification number of 16.

Low viscosity polymers can also be produced in the above manner from low molecular weight 98-96/2-4 propylene/ethylene copolymers, 50/50 propylene/1-butene copolymer, 95/5 propylene/1-pentene copolymer, 90/10 propylene/1-hexene copolymer, 80/20 propylene/4-methyl-1-pentene copolymer, 75/25 propylene/1-dodecene copolymer and 90/10 1-butene/hexene copolymer. In general, propylene copolymerized with another alpha olefin, including ethylene.

The procedure for the use of a maleic anhydride modified polypropylene homopolymer or copolymer, when this material is interblended into the base layer is exemplified by the following technique. A maleic anhydride modified polypropylene e.g., Epolene E-43, a maleic anhydride modified polypropylene obtained from Eastman Kodak Company, melt-blended with a polypropylene homopolymer such as Exxon 4252 (85 parts) to give a 15% master batch. Twenty parts of the master batch is dry-blended with 80 parts of the polypropylene homopolymer to give a resin blend containing 3% of the maleic anhydride modified polypropylene. This blend will contain sufficient maleic anhydride-modified polypropylene at the surface of the substrate to aggressively bond poly(vinyl alcohol) thereto. An alternative method of making available the maleic anhydride-modified polypropylene homopolymer or copolymer at the surface of the substrate is to coextrude the base polymer with a skin layer containing the maleic anhydride-modified polymer.

According to another aspect of the invention there is provided a method of forming a metallized film combination as defined in claim 12.

The metal ion used in this method is preferably sodium or zinc, and the metal layer used in this method is preferably aluminum.

The first embodiment of the invention will now be described in more detail. The substrates in this embodiment include any polymeric film substrate which inherently permits the transmission of oxygen and water vapor and wherein the utility of such film would call for a minimization of such transmission. In most cases, the source of oxygen and water vapor referred to herein is atmospheric oxygen and water vapor. While nylon, polyethylene terephthalate, polycarbonate, etc. films are contemplated herein, the particularly preferred class of films are the polyolefins. Within the polyolefin class, homopolymers and copolymers of propylene are preferred. Particularly preferred are isotatic polypropylenes containing at least 80% by weight of isotatic polypropylene. The preferred base substrate layer can be a homopolypropylene having a melting point range of from about 321° to about 336°F. A commercially available material of this description is Exxon 4252 or Fina 3378. Copolymers of propylene with another alpha olefin, preferably ethylene can also be employed.

The vinyl alcohol polymers employed herein can be any commercially available material. For example, Vinol 125, 99.3 +% super hydrolized polyvinyl alcohol, or Vinol 325, 98% hydrolyzed polyvinyl alcohol obtained from Air Products Inc. The vinyl alcohol polymers include ethylene/vinyl alcohol copolymers obtained from any commercial source. For example, ethylene-vinyl alcohol copolymer (EVOH) is available under the name EVAL from Kura Ray Company, Ltd. of Japan. This material contains about 80% of vinyl alcohol.

The ethylene-acrylic acid copolymer is produced by the high pressure copolymerization of ethylene and acrylic acid. When ethylene is copolymerized with acrylic acid the molecular structure is significantly altered by the random inclusion of bulky carboxyl groups along the backbone and side chains of the copolymer. The carboxyl groups are free to form bonds and interact with any polar substrate; they can also hydrogen-bond together to yield toughness; and the carboxyl groups inhibit crystallization which results in clarity, lower melting and softening point. The ethylene-acrylic acid copolymers consists essentially of about 96 mole % methylene groups, thus, their water resistance is understandably similar to that of polyethylene. The ammonium salts of the copolymers permit water dispersions of the material to be formed which facilitates ease of topical application to surfaces. These copolymers can be formed having melt indexes ranging from about 300 to 3000. Commercially available examples of these copolymers are PRIMACOR 4983 (Dow Chemical Co.), an aqueous dispersion having 25% solids content and obtained from the reaction between approximately 20 wt % acrylic acid and 80 wt % ethylene; and Michem Prime 4983 available from Michelman Corporation.

The blend of (a) and (b) supra may be further modified by additives and/or modifiers such as wax emulsions, colloidal silica dispersions, antiblocking agents, defoamers, and crosslinkers.

As indicated above, to obtain good adhesion between the metal film and the surface of the blend of the present invention, it is preferred to subject the surface to a corona discharge treatment. This is a conventional treatment and is carried out in a known manner to a dyne value of about 36-60 dynes/cm and preferably 40-50 dynes/cm.

The metal coating can be applied to the corona-treated blend-layer by any known method, such as, sputtering, vacuum deposition or electroplating. Vacuum deposition is a preferred method. The most frequently used coating metal is aluminum, although other metals such as gold, silver, chrome and copper are also contemplated.

In order to effectively inhibit the amount of oxygen transmitted through the base layer, the base layer must be coated with a barrier polymer such as a polyvinyl alcohol homopolymer or copolymer. However, polyvinyl alcohol has two drawbacks, (1) it adheres poorly to the preferred substrate layers unless the substrate is modified by a maleic anhydride grafted PP homopolymer or copolymer as a tie layer, and (2) it lacks good adhesion to the subsequently applied metal layer such as aluminum. It has been determined, however, if a blend of polyvinyl alcohol homopolymer or copolymer and an ethylene-acrylic acid copolymer is applied to the surface, a particularly aggressive bond is created. In addition, if this blend is applied after the substrate film has been machine direction oriented, then after the composite has been transverse direction oriented and a metal such as aluminum deposited on the surface, a uniquely ordered metal layer results.

In preparing the blend of the polyvinyl alcohol homopolymer or copolymer and the ethylene acrylic acid copolymer, the components ratio can range from 10:90 to 90:10 by dry weight. In preparing a roughly 50:50 blend in an aqueous dispersion for example 500 parts of a 10% solids, aqueous solution of Vinol 325 or 50 parts by dry weight of Vinol 325 (a 98% hydrolized medium viscosity polyvinyl alcohol, obtained from Air Products) can be mixed with 200 parts by weight of a 25% solids, aqueous dispersion of Michem 4983 or 50 parts by dry weight of Michem 4983 (an ethylene-acrylic acid copolymer obtained from Michelman, Inc.). This combination, adjusted to an aqueous 5% solids dispersion, will provide the polyvinyl alcohol to ethylene-acrylic acid comopolymer mixture in a dry weight ratio of approximately 50:50.

The second embodiment of the invention will now be described in more detail. The substrate may be the same as in the second embodiment described above; and the vinyl alcohol polymers may be the same as in the second embodiment.

The ionomer resin to be blended with the vinyl alcohol polymer may be characterized as a metal-containing ionic copolymer obtained by the reaction between ethylene or an alpha-olefin and an ethylenically unsaturated monocarboxylic acid such as acrylic acid or methacrylic acid wherein at least 10% of said carboxylic acid groups are neutralized by an alkali metal ion. In preparing these copolymers, the ethylene ranges from about 80-99 mol % with the unsaturated monocarboxylic acid ranging from about 1-20% and more preferably from about 1-10 mol %. The base copolymers are converted to ionic copolymers by reaction with an ionizable alkali metal compound, e.g., a sodium or zinc base. This reaction or neutralization is sufficient to at least neutralize 10% of the acid groups. A typical example of preparing an ionic copolymer comprises milling approximately a 500 gram sample of an ethylene-methacrylic acid copolymer containing about 10 mole % by weight of methacrylic acid and then adding thereto about 24 grams of sodium methoxide, dissolved in about 100 mls. of methanol. The sodium methoxide is added to the copolymer over a period of about 5 minutes and the copolymer is worked on the mill. Blending of the composition is continued for approximately 15 minutes, during which time the initial soft, fluid-melt becomes stiff and rubbery. A commercially available alkali salt of ethylene-methacrylic acid copolymer in the form of an aqueous dispersion is Petaflex 56220 obtained from Whittaker Chemical Co.

The blend of (a) and (b) supra may be further modified by additives and/or modifiers such as wax emulsions, colloidal silica dispersions, antiblocking agents, defoamers, and crosslinkers.

As indicated above, to obtain good adhesion between the metal film and the surface of the blend of the present invention, it is preferred to subject the surface to a corona discharge treatment. This is a conventional treatment and is carried out in a known manner to a value of about 36-60 dynes/cm and preferably 40-50 dynes/cm.

The metal coating can be applied to the corona-treated blend-layer by any known method, such as, sputtering, vacuum deposition or electroplating. Vacuum deposition is a preferred method. The most frequently used coating metal is aluminum, although other metals such as gold, silver, chrome and copper are also contemplated.

In order to effectively inhibit the amount of oxygen transmitted through the base layer, the base layer must be coated with a barrier polymer such as a polyvinyl alcohol homopolymer or copolymer. However, polyvinyl alcohol has two drawbacks, (1) it adheres poorly to the preferred substrate layers unless the substrate is modified by a maleic anhydride grafted polypropylene homopolymer or copolymer as a tie layer, and (2) it lacks good adhesion to the subsequently applied metal layer such as aluminum. It has been determined, however, if a blend of polyvinyl alcohol homopolymer or copolymer and the ionomer is applied to the surface, a particularly aggressive bond is created. In addition, if this blend is applied after the substrate film has been machine direction oriented, then after the composite has been transverse direction oriented and a metal such as aluminum deposited on the surface, a uniquely ordered metal layer results.

In preparing the blend of the polyvinyl alcohol homopolymer or copolymer and the ionomer, the components ratio can range from 10:90 to 90:10 by dry weight. In preparing a roughly 50:50 blend in an aqueous dispersion for example 500 parts of a 10% solids aqueous solution of Vinol 325 or 50 Parts by dry weight of Vinol 325 (a 98% hydrolyzed medium viscosity polyvinyl alcohol, obtained from Air Products) can be mixed with 156.3 parts by weight of a 32% solids aqueous dispersion of Petaflex 56220 or 50 parts by dry weight of Petaflex 56220 (an alkali salt of ethylene-methacrylic acid copolymer). This combination, adjusted to an aqueous 5% solids dispersion, will provide the polyvinyl alcohol to ionomer mixture in a ratio of approximately 50:50.

The following examples illustrate the invention: examples 1 to 11 and comparative examples A to C relate to the first embodiment; and example 12 and comparative example D relate to the secd embodiment.

### Example 1

An aqueous coating dispersion of 5% solids was placed in a gravure coater which was located between the machine direction (MD) orienter and the transverse direction (TD) orienter of a film orienter. The aqueous coating is composed of 10 parts by dry weight of Vinol 325 and 90 parts by dry weight of Michem 4983. A polypropylene homopolymer (Exxon 4252) and an ethylene-propylene-butene-1 terpolymer skin resin containing 2000ppm of erucamide slip were coextruded at a weight ratio of 97/3 through a flat sheet die at 250°C, cast onto a cooling drum and quenched at 30°C. The terpolymer skin on one side of the film provided a heat-seal layer. The coextruded sheet, measuring about 30 mil thick, was reheated to 140°C and stretched 5-fold MD and corona discharge treated on the homopolymer side for improved surface wettability. When passing through the gravure coater, the MD oriented film web, now about 6 mil thick, was coated on the homopolymer surface with the aqueous dispersion blend. The coated web was dried in pre-heat zones at 160°C, then stretched 8-fold TD and annealed at 160°C. The biaxially stretched film, measuring 0.8 mil, was corona discharge treated on the blend coated side before being wound into a film roll. The resultant coated film had a % haze of 1.6 and a gloss of 85.4.

### Example 2

In a manner similar to Example 1, an aqueous coating dispersion of 5% solids comprising 25 parts by dry weight of Vinol 325 and 75 parts by dry weight of Michem 4983 was coated on the MD-oriented coextruded film. The resultant film had a % haze of 1.3 and a gloss of 89.3.

### Example 3

An aqueous coating dispersion of 5% solids comprising 50 parts by dry weight of Vinyl 325 and 50 parts by dry weight of Michem 4983 was coated on the same MD-oriented, coextruded film as described in Example 1. The resultant film had a % haze of 1.1 and a gloss of 90.3.

### Example 4

An aqueous coating dispersion of 5% solids comprising 75 parts by dry weight of Vinyl 325 and 25 parts by dry weight of Michem 4983 was coated on the same MD-oriented, coextruded film as described in Example 1. The resultant film had a % haze of 1.3 and a gloss of 88.9.

### Example 5

In a manner similar to Example 1, an aqueous coating dispersion of 5% solids comprising 50 parts by dry weight of Vinol 125 (99.3+% super hydrolzyed polyvinyl alcohol, obtained from Air Products) and 50 parts by dry weight of Michem 4983 was coated on the MD-oriented coextruded film. The resultant coated film had a coating weight of 0.15 mg/sq. in. and good transparency.

### Example 6

In a manner similar to Example 1, an aqueous dispersion of 5% solids consisting of 50 parts by dry weight of Vinol 325 and 50 parts of dry weight of Michem 4983, and 5 parts by dry weight of Michem Lube 193 (No. 1 carnauba was obtained from Michelman Corp.) was coated on the MD-oriented coextruded film. The resultant film had a coating weight of 0.16 mg/sq. in. and good transparency.

### Example 7

In a manner similar to Example 1, an aqueous coating dispersion of 5% solids consisting of 50 parts by dry weight of Vinol 125 and 50 parts by dry weight of Michem 4983, was coated on an MD-oriented PP homopolymer film (Fina 3378). The resultant film had good transparency and excellent barrier properties after it was metallized by aluminum.

### Example 8

In a manner similar to Example 1, an aqueous coating dispersion of 5% solids consisting of 50 parts by dry weight of Vinol 125 and 50 parts by dry weight of Michem 4983, 2.5 parts by dry weight of Cymel 373 (melamine-formaldehyde cross linker) and 1 part by dry weight of an ammonium salt of p-toluene sulfonic acid (catalyst) was coated on the same MD-oriented PP homopolymer. The resultant film had good transparency and excellent barrier properties after the film was metallized.

### Example 9

In a manner similar to Example 1, an aqueous coating dispersion of 5% solids consisting of 50 parts by dry weight of Vinol 325 and 50 parts by dry weight of Michem 4983, was coated on the same coextruded film except that the polypropylene skin layer was modified with 3% Epolene E-43 (a low MW polypropylene wax containing maleic anhydride functionality, obtained from Eastman Kodak). The resultant film had a coating weight of 0.15 mg/sq. in. and good transparency.

### Example 10

In a manner similar to Example 1, an aqueous coating dispersion of 5% solids consisting of 62 parts by dry weight of Vinol 325 and 38 parts by dry weight of Michem 4983 was coated on the Epolene E-43 modified surface. The resultant film had a coating weight of 0.24 mg/sq. in. and good transparency.

### Example 11

In a manner similar to Example 1, an aqueous coating dispersion of 5% solids consisting of 75 parts by dry weight of Vinol 325 and 25 parts by dry weight of Michem 4983 was coated on the Epolene E-43 modified surface. The resultant film had good transparency. Its coating weight, however, could not be accurately measured.

### Comparative Example A

A control film example was prepared in a manner similar to Example 1 except that the aqueous coating was omitted. The homopolymer surface was treated with corona discharge to give a surface tension of 38 dynes/cm. The uncoated film had a percent haze of 1.5 and a gloss of 88.4.

### Comparative Example B

An additional control film sample was prepared in a manner similar to Example 1 except the coating was composed of 5% solids aqueous dispersion of Michem 4983. The resultant film had a percent haze of 1.5 and a gloss of 88.5.

### Comparative Example C

A further control film sample was prepared in a manner similar to Example 1 except that the coating was composed of 5% solids aqueous solution of Vinol 325.

All of the above examples 1 to 11 and A to C were vacuum-deposited with aluminum employing techniques well known in the art. These films were compared interms of (1) metal adhesion to the film surface and (2) barrier properties. The adhesion was evaluated by peeling off the coating using 610 Scotch tape. The barrier properties were characterized by oxygen transmission rate (OTR) and water vapor transmission rate (WVTR), using Ox-Tran 1050 A and Permatran-W, respectively. Both of these instruments were manufactured by Modern Controls, Inc. The results are shown in Table 1.

**TABLE 1**

| Example | Blend Composition | Metallized Film | | |
|---|---|---|---|---|
| | | Adhesion (1) | OTR (2) | WVTR (3) |
| 1 | 10/90 Vi.325/Mi.4983 | 10 | 7.1 | 0.16 |
| 2 | 25/75 Vi.325/Mi.4983 | 10 | 6.3 | 0.17 |
| 3 | 50/50 Vi.325/Mi.4983 | 9 | 1.3 | 0.06 |
| 4 | 75/25 Vi.325/Mi.4983 | 4 | 0.61 | 0.11 |
| 5 | 50/50 Vi.125/Mi.4983 | 10 | 1.2 | 0.03 |
| 6 | 50/50 Vi.325/Mi.4983 +5% Michem 193 | 10 | 1.2 | 0.04 |
| 7 | 50/50 Vi.125/Mi.4983 | 10 | 0.32 | 0.005 |
| 8 | 50/50 Vi.125/Mi.4983 +2.5% Cymel 373 + 1% Ammonium salt of p-TSA | 10 | 0.20 | -- |
| 9 | 50/50 Vi.325/Mi. 4983 | 10 | 1.2 | 0.04 |
| 10 | 62/38 Vi.325/Mi. 4983 | 10 | 0.78 | 0.07 |
| 11 | 75/25 Vi.325/Mi. 4983 | 10 | 0.66 | 0.08 |
| A | None | 8 | 15 | 0.11 |
| B | 0/100 Vi.325/Mi.4983 | 10 | 13 | 0.10 |
| C | 100/0 Vi.325/Mi.4983 | 0 | -- | -- |

| | | | | |
|---|---|---|---|---|
| (1) 10 = best (0% coating peel-off), 0 = worst (100% coating peel-off). | | | | |
| (2) Oxygen transmission rate, measured in cc/100 sq.in./24 hr. at 0% RH and 86°F. | | | | |
| (3) Water vapor transmission rate, measured in gm/100 sq.in./24 hr. at 100% RH and 100°F. | | | | |

### Example 12

An aqueous coating dispersion of 5% solids was placed in a gravure coater, which was located between the MD orienter and the TD of a film orienter. The coating was composed of 50 parts by dry weight of Vinol 325 (a 98% hydrolyzed, medium viscosity polyvinyl alcohol obtained from Air Products) and 50 parts by dry weight of Petaflex 56220 (an alkali salt of ethylene-methacrylic acid copolymer obtained from Whittaker Chemical Co). A polypropylene homopolymer (Exxon 4252) and an ethylene-propylene-butene-1 terpolymer skin resin containing 2000ppm of erucamide slip additive were coextruded at a weight ratio of 97-3 through a flat sheet die at 250°C, cast onto a cooling drum and quenched at 30°C. The coextruded sheet measuring about 30 mil thick, was reheated to 140°C and stretched 5-fold MD, than corona treated on the homopolymer side for improved surface wettability. When passing through the gravure coater, the MD oriented film web, now about 6 mils thick, was coated on the homopolymer surface with the aqueous dispersion. The coated web was dried in pre-heat zones at 160°C, then stretched 8-fold in TD and annealed at 160°C. The biaxially stretched film measuring 0.8 mil, was corona treated on the coated side before it was wound into a film roll. The resultant coated film had a coating weight of 0.20 mg/sq. in and good clarity.

### Comparative Example D

A control film sample was prepared in a manner similar to Example 12 except that the aqueous coating was omitted. The homopolymer surface was treated with corona discharge to give a surface tension of 38 dynes/cm. The uncoated film had a percent haze of 1.5 and a gloss of 88.4.

The above examples 12 and D were vacuum-deposited with aluminum in a conventional manner. These films were compared with each other in terms of (1) metal adhesion to the film surface and (2) barrier properties. The adhesion was evaluated by peeling off the coating using 610 Scotch tape. The barrier properties were characterized by oxygen transmission rate (OTR) and water vapor transmission (WVTR), using Ox-tran 1050 A and Permatran-W, respectively. Both of these instruments were manufactured by Modern Controls, Inc. These results are shown in Table 2.

**TABLE 2**

| Example | Primer Composition | Metallized Film | | |
|---|---|---|---|---|
| | | Adhesion (1) | OTR (2) | WVTR (3) |
| 12 | 50/50 PVOH/Ionomer | 10 | 1.8 | 0.06 |
| A | None | 8 | 15 | 0.11 |

| | | | | |
|---|---|---|---|---|
| (1) 10 = best (0% coating peel-off), 0 = worst (100% coating peel-off). | | | | |
| (2) Oxygen transmission rate, measured in cc/100 sq.in./24 hr. at 0% RH and 86°F. | | | | |
| (3) Water vapor transmission rate, measured in gm/100 sq.in./24 hr. at 100% RH and 100°F. | | | | |

## Claims

1. A metallized film structure comprising a polymer substrate at least one surface thereof having a skin layer thereon, and a metal layer on the surface of the skin layer, wherein said skin layer is either:
(i) a blend of (a) a vinyl alcohol homo or copolymer and (b) an ethylene-acrylic acid copolymer; or
(ii) a blend of (a) a vinyl alcohol homopolymer or copolymer and (b) an ionic copolymer of ethylene and an ethylenically unsaturated monocarboxylic acid wherein at least 10% of the carboxylic acid groups are neutralized with an alkali metal ion.

2. A structure according to claim 1, wherein the polymer substrate is polypropylene or a copolymer thereof.

3. A structure according to claim 1 or 2, wherein in (i) or (ii) the ratio of (a) to (b) is from 10:90 to 90:10.

4. A structure according to claim 1, 2 or 3, wherein said blend (i) is a blend of (a) a member selected from the group consisting of polyvinyl alcohol and ethylene-vinyl alcohol copolymer and (b) an ethylene-acrylic acid polymer.

5. A structure according to claim 1, 2 or 3, wherein said blend (ii) is a blend of (a) a member selected from the group consisting of polyvinyl alcohol and ethylene-vinyl alcohol copolymer and (b) an alkali metal salt of ethylene acrylic acid coplymer or ethylene methacrylic acid coplymer.

6. A structure according to claim 1, 2 or 3, wherein said blend is of (a) polyvinyl alcohol and (b) an ethylene-acrylic acid copolymer.

7. A structure according to claim 1, 2, or 3, wherein said blend (ii) comprises (a) polyvinyl alcohol and (b) an alkali metal salt of ethylene acrylic acid copolymer.

8. A structure according to claim 1, 2, or 3, wherein said blend (ii) comprises (a) polyvinyl alcohol and (b) an alkali metal salt of ethylene-methacrylic acid copolymer.

9. A structure according to claim 4 or 5, wherein one side of said polypropylene substrate carries a heat-seal skin layer.

10. A structure according to claim 9, wherein said heat-seal skin layer is a copolymer of ethylene and propylene or a terpolymer of ethylene, propylene and butene-1.

11. A structure according to claim 9 or 10, wherein the other side of said polypropylene substrate is modified by a maleic anhydride grafted polypropylene homopolymer or copolymer.

12. A method of forming a metallized film combination comprising: (a) providing a polymeric substrate layer susceptible in its unmodified form of transmitting oxygen and moisture; (b) machine direction orienting said film; (c) coating at least one side of said substrate layer with a blend of (1) a vinyl alcohol homopolymer or copolymer and either (2) an ethylene-acrylic acid copolymer or (3) an ionic copolymer of ethylene and an ethylenically unsaturated monocarboxylic acid wherein at least 10% of the carboxylic acid groups are neutralized with a metal ion; (d) transverse direction orienting said film; and (e) depositing a metal layer on the surface of said blend.

13. A method according to claim 12, wherein said metal ion is sodium or zinc and said metal layer is aluminum.

## Patentansprüche

1. Metallisierte Folienstruktur, enthaltend ein Polymersubstrat, bei dem auf mindestens einer Oberfläche eine Hautschicht vorliegt, und mit einer Metallschicht auf der Oberfläche der Hautschicht, wobei die Hautschicht
(i) ein Gemisch aus (a) einem Vinylalkoholhomopolymer oder -copolymer und (b) einem Ethylen-Acrylsäure-Copolymer oder
(ii)ein Gemisch aus (a) einem Vinylalkoholhomopolymer oder -copolymer und (b) einem ionischen Copolymer aus Ethylen und einer ethylenisch ungesättigten Monocarbonsäure, worin mindestens 10% der Carbonsäuregruppen mit einem Alkalimetallion neutralisiert sind,
ist.

2. Struktur nach Anspruch 1, worin das Polymersubstrat ein Polypropylen oder ein Copolymer hiervon ist.

3. Struktur nach Anspruch 1 oder 2, worin in (i) oder (ii) das Verhältnis von (a) zu (b) bei 10:90 bis 90:10 liegt.

4. Struktur nach Anspruch 1, 2 oder 3, worin das Gemisch (i) ein Gemisch aus (a) einer Komponente, die aus den Stoffen Polyvinylalkohol und Ethylen-Vinylalkohol-Copolymer, ausgewählt ist, sowie (b) einem Ethylen-Acrylsäure-Polymer ist.

5. Struktur nach Anspruch 1, 2 oder 3, worin das Gemisch (ii) ein Gemisch aus (a) einer Komponente, die aus den Stoffen Polyvinylalkohol und Ethylen-Vinylalkohol-Copolymer, ausgewählt ist, sowie (b) einem Alkalimetallsalz eines Ethylen-Acrylsäure-Copolymers oder eines Ethylen-Methacrylsäure-Copolymers ist.

6. Struktur nach Anspruch 1, 2 oder 3, worin das Gemisch aus (a) Polyvinylalkohol und (b) einem Ethylen-Acrylsäure-Copolymer besteht.

7. Struktur nach Anspruch 1, 2 oder 3, worin das Gemisch (ii) die Komponenten (a) Polyvinylalkohol und (b) ein Alkalimetallsalz eines Ethylen-Acrylsäure-Copolymers enthält.

8. Struktur nach Anspruch 1, 2 oder 3, worin das Gemisch (ii) die Komponenten (a) Polyvinylalkohol und (b) ein Alkalimetallsalz eines Ethylen-Methacrylsäure-Copolymers enthält.

9. Struktur nach Anspruch 4 oder 5, worin eine Seite des Polypropylensubstrats eine Heißsiegel-Hautschicht trägt.

10. Struktur nach Anspruch 9, worin die Heißsiegel-Hautschicht ein Copolymer aus Ethylen und Propylen oder ein Terpolymer aus Ethylen, Propylen und Buten-1 ist.

11. Struktur nach Anspruch 9 oder 10, worin die andere Seite des Polypropylensubstrats durch ein mit Maleinsäureanhydrid gepfropftes Polypropylenhomopolymer oder -copolymer modifiziert ist.

12. Verfahren zur Herstellung einer metallisierten Folienkombination mit folgenden Schritten: (a) Bereitstellen einer Polymersubstratschicht, die in ihrer unmodifizierten Form für Sauerstoff und Feuchtigkeit durchlässig ist; (b) Orientieren der Folie in der Maschinenrichtung; (c) Beschichten von mindestens einer Seite der Substratschicht mit einem Gemisch aus (1) einem Vinylalkoholhomopolymer oder -copolymer sowie (2) einem Ethylen-Acrylsäure-Copolymer oder (3) einem ionischen Copolymer aus Ethylen und einer ethylenisch ungesättigten Monocarbonsäure, worin mindestens 10 % der Carbonsäuregruppen mit einem Metallion neutralisiert sind; (d) Orientieren der Folie in der Querrichtung; und (e) Niederschlagen einer Metallschicht auf der Oberfläche des genannten Gemisches.

13. Verfahren nach Anspruch 12, worin das Metallion Natrium oder Zink und die genannte Metallschicht Aluminium ist.

## Revendications

1. Une structure de film métallisée comprenant un substrat polymère dont au moins l'une des surfaces est revêtue d'une couche de peau et une couche métallique sur la surface de la couche de peau, dans laquelle la couche de peau est soit:
(i) un mélange de (a) un homopolymère ou copolymère d'alcool vinylique et (b) un copolymère éthylène-acide acrylique; ou
(ii) un mélange de (a) un homopolymère ou copolymère d'alcool vinylique et (b) un copolymère ionique d'éthylène et d'un acide monocarboxylique insaturé éthyléniquement dans lequel au moins 10% des groupes acide carboxylique sont neutralisés par un ion de métal alcalin.

2. Une structure selon la revendication 1, dans laquelle le substrat de polymère est du polypropylène ou l'un de ces copolymères.

3. Une structure selon la revendication 1 ou 2, dans laquelle dans (i) ou (ii), le rapport de (a) à (b) est de 10/90 à 90/10.

4. Une structure selon la revendication 1, 2 ou 3, dans laquelle ledit mélange (i) est un mélange de (a) un élément choisi dans le groupe constitué par alcool polyvinylique et copolymère éthylène-alcool vinylique et (b) un polymère éthylène-acide acrylique.

5. Une structure selon la revendication 1, 2 ou 3, dans laquelle ledit mélange (ii) est un mélange de (a) un élément choisi dans le groupe constitué par alcool polyvinylique et copolymère éthylène-alcool vinylique et (b) un sel de métal alcalin d'un copolymère éthylène-acide acrylique ou d'un copolymère éthylène-acide méthacrylique.

6. Une structure selon la revendication 1, 2 ou 3, dans laquelle ledit mélange est un mélange de (a) alcool polyvinylique et (b) un copolymère éthylène-acide acrylique.

7. Une structure selon la revendication 1, 2 ou 3, dans laquelle ledit mélange (ii) comprend (a) l'alcool polyvinylique et (b) un sel de métal alcalin du copolymère éthylène-acide acrylique.

8. Une structure selon la revendication 1, 2 ou 3, dans laquelle ledit mélange (ii) comprend (a) l'alcool polyvinylique et (b) un sel de métal alcalin de copolymère éthylène-acide méthacrylique.

9. Une structure selon la revendication 4 ou 5, dans laquelle l'une des faces dudit substrat de polypropylène porte une couche de peau thermosoudable.

10. Une structure selon la revendication 9, dans laquelle ladite couche de peau thermosoudable est un copolymère d'éthylène et de propylène ou un terpolymère d'éthylène, propylène et de butène-1.

11. Une structure selon la revendication 9 ou 10, dans laquelle l'autre face dudit substrat de polypropylène est modifiée par un homopolymère ou un copolymère de polypropylène greffé par de l'anhydride maléique.

12. Un procédé de formation d'une combinaison de film métallisé comprenant les étapes suivantes: (a) utilisation d'une couche de substrat polymère susceptible, sous sa forme non modifiée, de transmettre l'oxygène et l'humidité; (b) orientation selon la direction de la machine dudit film; (c) revêtement d'au moins l'une des faces de ladite couche de substrat par un mélange de (1) un homopolymère ou copolymère d'alcool vinylique et soit (2) un copolymère éthylène-acide acrylique, soit (3) un copolymère ionique d'éthylène et d'un acide monocarboxylique éthyléniquement insaturé dans lequel au moins 10% des groupes acide carboxylique sont neutralisés par un ion métallique; (d) orientation dudit film selon la direction transversale; et (e) dépôt d'une couche de métal à la surface dudit mélange.

13. Un procédé selon la revendication 12, dans lequel ledit ion métallique est le sodium ou le zinc et ladite couche métallique est constituée d'aluminium.
